# EUROPEAN PATENT APPLICATION

(11) **EP 2 253 918 A2**
(43) Date of publication of application: **24.11.2010**
(21) Application number: 10163002.8
(22) Date of filing: 17.05.2010
(51) Int. Cl.: F28D 15/04, H01L 23/427

(54) **Enclosure For Heat Transfer Devices, Methods Of Manufacture Thereof And Articles Comprising The Same**

(30) Priority: 22.05.2009 US 470723
(71) Applicant: General Electric Company, Schenectady, NY 12345 (US)
(72) Inventor: Weaver Jr., Stanton Earl, Northville, NY 12134 (US); Chauhan, Shakti Singh, Niskayuna, NY 12309 (US); Knobloch, Aaron Jay, Mechanicville, NY 12118 (US); Kulkarni, Ambarish Jayant, Niskayuna, NY 12309 (US); Varanasi, Kripa Kiran, Cambridge, MA 02142 (US)
(74) Representative: Illingworth-Law, William Illingworth

(57) **Abstract**

Disclosed herein is a heat transfer device (100) that includes a shell (102); the shell (102) being an enclosure that prevents matter from within the shell (102) from being exchanged with matter outside the shell (102) during the operation of the heat transfer device (100); the shell (102) having an outer surface (111 and 121) and an inner surface (109 and 119); and a porous layer disposed on the inner surface (109 and 119) of the shell (102); the porous particle layer (160) having a thickness effective to enclose a vapor space (150) between opposing faces; the vapor space (150) being effective to provide a passage for the transport of a fluid; the heat transfer device (100) having a thermal conductivity of greater than or equal to about 10 watts per meter-Kelvin and a coefficient of thermal expansion that is substantially similar to that of a semiconductor.

## Description

### BACKGROUND OF THE INVENTION

This disclosure relates to enclosures for heat transfer devices, methods of manufacture thereof and to articles comprising the same.

Heat transfer devices such as, for example, a heat pipe, vapor chamber or thermal ground plane that are generally used in supercomputers and other facilities (e.g., nuclear plants, power generation facilities, and the like) are made from high thermal conductivity materials such as copper or aluminum and take the form of cylindrical tubes, flat spreaders or a combination thereof. To be effective the heat transfer device is intimately attached to a hot surface of an object that is to be cooled. Concerns can arise when there is a mismatch in the thermal expansion between the heat transfer device and the object to be cooled. A compliant layer is then be used between the heat transfer device and the object to be cooled to account for the mismatch and reduce the stresses brought on by the differences between the respective coefficients of thermal expansions. In general, materials used as compliant inter-layers are low in thermal conductivity and tend to reduce the overall effectiveness of the heat transfer device. There therefore exists a need for an envelope for a heat transfer device that has a coefficient of thermal expansion that is closely matched to semiconductor materials used in microelectronics (examples of which are silicon, silicon carbide, gallium nitride, and the like) or to metals used in power generation facilities (examples of which are pure titanium, tungsten, molybdenum, steels, cast iron, aluminum, copper, or alloys thereof, and the like).

### BRIEF DESCRIPTION OF THE INVENTION

Disclosed herein is a heat transfer device that includes a shell; the shell being an enclosure that prevents matter from within the shell from being exchanged with matter outside the shell during the operation of the heat transfer device; the shell having an outer surface and an inner surface; and a porous layer disposed on the inner surface of the shell; the porous particle layer having a thickness effective to enclose a vapor space between opposing faces; the vapor space being effective to provide a passage for the transport of a fluid; the heat transfer device having a thermal conductivity of greater than or equal to about 10 watts per meter-Kelvin and a coefficient of thermal expansion that is substantially similar to that of a semiconductor.

Disclosed herein too is a method for manufacturing a heat transfer device comprising disposing a particle layer upon a first portion and a second portion of a shell; the particle layer being porous; the first portion and the second portion each having a thermal conductivity of greater than or equal to about 10 watts per meter-Kelvin and a coefficient of thermal expansion that is substantially similar to that of a semiconductor; and disposing a seal ring and/or a metal stack between the first portion and the second portion of the shell; where the first portion and the second portion are sealed in a manner to prevent matter from within the shell from being exchanged with matter outside the shell during the operation of the heat transfer device.

### BRIEF DESCRIPTION OF THE DRAWINGS

Figure 1 is an exemplary depiction of the heat transfer device;
Figure 2 depicts a plan view and a side view of the second portion of the shell when viewed along the section AA' of the Figure 1;
Figure 3 depicts a plan view and a side view of the first portion of the shell when viewed along the section BB' of the Figure 1;
Figure 4 depicts ribs disposed upon the inner surface of the first portion;
Figure 5(a) depicts a heat transfer device with the seal region encircled;
Figure 5(b) depicts an expanded view of the encircled seal region of the Figure 5(a) and depicts an untextured surface for accommodating the seal ring and/or the metal stack;
Figure 5(c) and 5(d) depict respective expanded views of the encircled seal region of the Figure 5(a) and depict textured surfaces for accommodating the seal ring and/or the metal stack;
Figures 6(a), (b), (c) and (d) depict various methods that can be employed to fill the shell with the fluid; and
Figures 7(a), (b) and (c) depict various exemplary methods that can be assemble the heat transfer device.

### DETAILED DESCRIPTION OF THE INVENTION

The disclosure will be described more fully hereinafter with reference to the accompanying drawings, in which exemplary embodiments are shown. As one would realize, the described embodiments may be modified in various different ways, all without departing from the spirit or scope of the invention.

In the drawings, the thickness of layers, films, panels, regions, and the like, are exaggerated for clarity. Like reference numerals designate like elements throughout the specification. It will be understood that when an element such as a layer, film, region, or shell is referred to as being "on" another element, it can be directly on the other element or intervening elements may also be present. In contrast, when an element is referred to as being "directly on" another element, there are no intervening elements present.

It will be understood that, although the terms first, second, third, and the like, may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "lower," "under," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" or "under" relative to other elements or features would then be oriented "upper" or "over" relative to the other elements or features. Thus, the exemplary term "under" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments should not be construed as limited to the particular shapes of regions illustrated herein but are to include deviations in shapes that result, for example, from manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The term "comprising" as used herein may be substituted by "consisting of" or "consisting essentially of". In addition, the use of the term "about" preceding a numeral is intended to include that numeral. For example, the use of the phrase "about 0.1 to about 1" is intended to mean that both 0.1 and 1 are included in the range. In addition, all numbers and ranges disclosed herein are interchangeable.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Disclosed herein is a heat transfer device having a shell that has a thermal conductivity of greater than or equal to about 10 watts per meter-kelvin (W/mK) while at the same time having a coefficient of thermal expansion that is substantially similar to that of typical semiconductor materials. The heat transfer device is an enclosed device that comprises a shell having a porous layer disposed thereon. The pores of the porous layer are completely or partially filled with liquid. Disposed between opposing faces of the porous layer is a vapor space that permits the transport of a vapor. The shell contacts a heat source and a heat sink and is closed, i.e., there is no exchange of matter from outside the shell with that inside the shell during the operation of the heat transfer device. When the heat transfer device contacts a heat source, liquid inside the porous media evaporates and a vapor is generated locally which is transported from the heat source end and transported to the heat sink end, by the pressure differential, where it condenses on the porous media which releases the heat to the heat sink.

By using a shell that comprises materials that can rapidly transfer heat from a heat source into the fluid and that have a coefficient of thermal expansion that is close to semiconductors, stresses can be minimized and long term damage to the device can be reduced. In one embodiment, the coefficient of thermal expansion is between about - 10 to +10 parts per million per degree Kelvin (ppm/K) when measured at room temperature (RT) of 25°C.

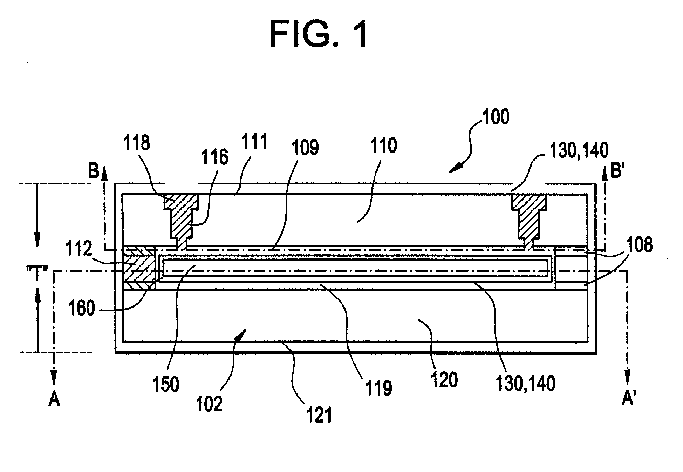

With reference now to the Figure 1, the heat transfer device 100 comprises a shell 102. The shell comprises a first portion 110 and a second portion 120, with the first portion 110 being disposed upon and in contact with the second portion 120. Disposed at the interface where the first portion 110 contacts the second portion 120 is a seal ring 112 and a metal stack 108 for promoting adhesion with the seal ring 112. In one embodiment, the metal stack 108 and the seal ring 112 facilitate the locking of the first portion 110 with the second portion 120. The first portion 110 and the second portion 120 (of the shell 102) each have an inner surface 109 and 119 and an outer surface 111 and 121 respectively. Both the respective inner surfaces 109 and 119 and the outer surfaces 111 and 121 can optionally have disposed upon them a passivation layer 130 and/or a stack for adhesion 140. While only a single passivation layer is depicted as being disposed on the inner surfaces 109 and 119 and the outer surfaces 111 and 121 respectively, it is understood that multiple passivation layers and/or adhesive layers can be disposed upon a given surface. Disposed in the first portion 110 is a port 116 in which is disposed a plug 118. The port 116 facilitates refilling the heat transfer device with a fluid that enables heat and mass transfer during the operation of the heat transfer device.

Disposed between the first portion and the second portion is a space 150 through which fluid (e.g., liquid and/or vapors) travel and a particle layer 160 that contains the fluid (generally in is liquid state).

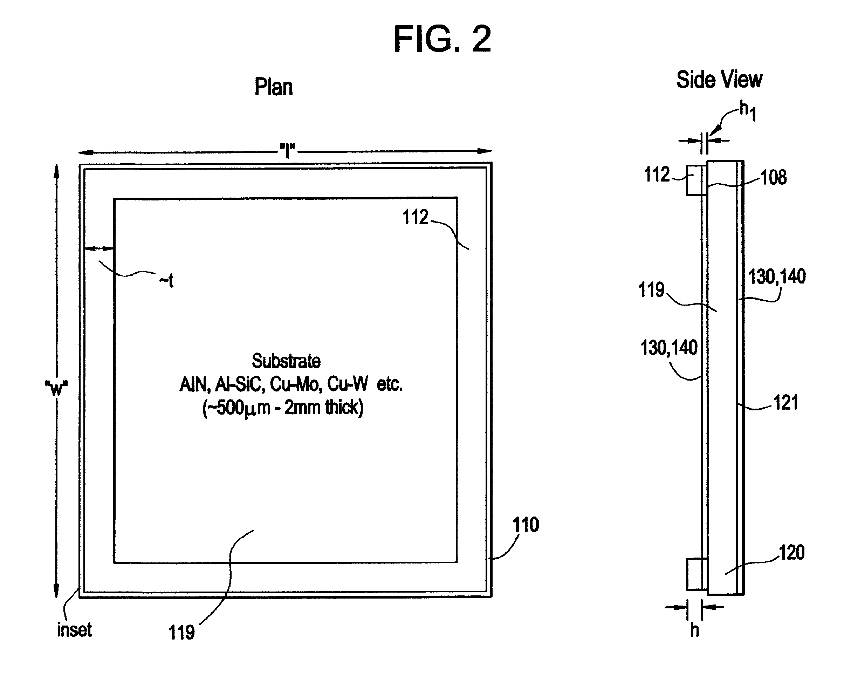

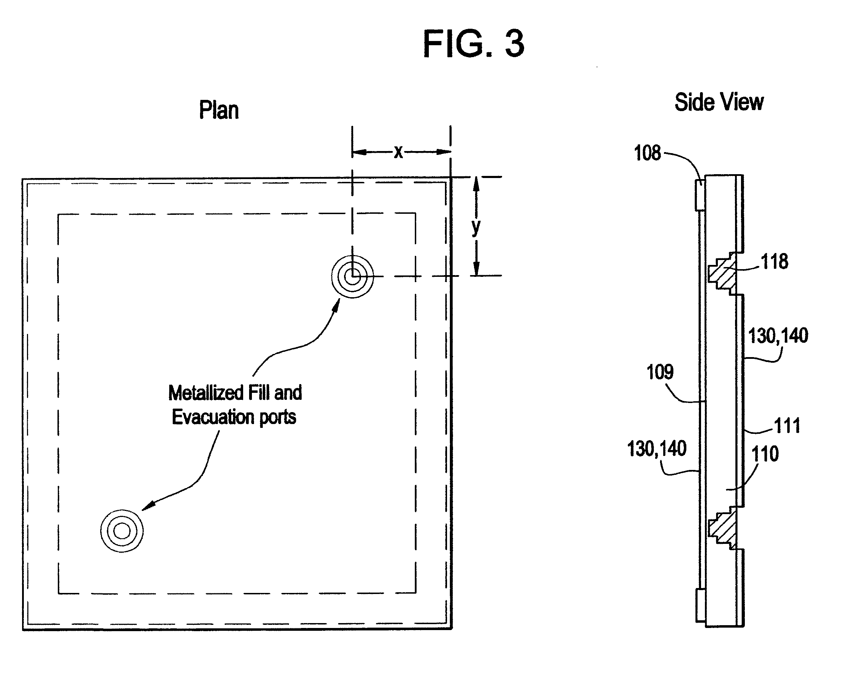

The Figure 2 depicts a plan view and a side view of the second portion 120 of the shell when viewed along the section AA' of the Figure 1, while the Figure 3 depicts a plan view and a side view of the first portion 110 of the shell 102 when viewed along the section BB' of the Figure 1. With reference now to the Figure 2, the surface area of the inner surface 119 of the second portion 120 of the shell 102 is slightly larger than the area that lies within the outer perimeter of the seal ring 112. This difference between these areas is referred to as an "inlet" in the Figure 2. Disposed between the seal ring 112 and the first portion 110 is the metal stack 108. The passivation layer 130 and/or the stack for adhesion 140 are disposed on both sides of the second portion 120.

Figure 3 depicts the first portion 110 of the shell 102 and shows a plurality of ports 116 disposed therein. The first portion 110 can contain two or more ports. In one embodiment, the first portion can contain 4 or more ports. Ports can be disposed in either the first portion 110 or in the second portion 120. In another embodiment, the first portion can contain 10 or more ports. The ports are used for filling and evacuating the heat transfer device with a fluid. Each port contains a plug 118 that can be removed when desired, but which provides an air-tight seal during operation of the heat transfer device. Alternatively, the port may be welded or soldered shut. The passivation layer 130 and/or the stack for adhesion 140 are disposed on both sides of the first portion 110 and the second portion 120 (Figure 2).

It is to be noted that while the first portion 110 and the second portion 120 of the shell 102 in the Figures 1, 2 and 3 are flat plates; each portion may have walls disposed on its periphery. This is not depicted in the Figures 1, 2 and 3. When the first portion 110 and the second portion 120 have walls, a seal ring 112 along with a metal stack 108 may be disposed between opposing walls that are disposed on the first portion 110 and the second portion 120 to form the heat transfer device 100. The wall can have a height of about 0.3 millimeter to about 2 millimeter. In one embodiment, the wall can have a height of about 0.5 millimeter to about 1 millimeter.

The shell can be a cylinder, a pyramid, a cube, an ellipsoid, a sphere, a rectangular cuboid, a geodesic dome, an n-sided antiprism, a cupola, a rhombohedron, a prism, or the like. While the Figures 2 and 3 depict the geometry of the cross-sectional area of the first and second portions as being square, they can be rectangular, triangular, polygonal, circular, or the like. Combinations of the aforementioned geometries can be used. An exemplary cross-section is a square or a rectangle.

The outer perimeter of the seal ring 112 is generally concentric to the outer perimeter of the shell 102. Thus, in one embodiment, the outer perimeter of the seal ring 112 may have a similar geometry as the outer perimeter of the shell 102.

The shell 102 has outer dimensions indicated as the length "1" and the width "w" in the Figure 2. While these dimensions are equivalent to each other because the area depicted in the Figure 2 is a square, they may not always be identical. In one embodiment, the length or width can be a length "1" of about 10 millimeters to about 1 meter. In one embodiment, the shell can have a length "1" of about 30 millimeters (mm) to about 0.75 meter. In another embodiment, the shell can have a length "1" of about 50 millimeters (mm) to about 0.50 meter. In yet another embodiment, the shell can have a length "1" of about 75 millimeters (mm) to about 0.25 meter. An exemplary length and width is about 3 centimeters to about 20 centimeters.

In one embodiment, the shell 102 can have an aspect ratio of greater than or equal to about 1. The aspect ratio is equal to the length "1" of heat transfer device divided by the largest linear cross-sectional dimension of the heat transfer device measured perpendicular to the length. In one embodiment, the shell 102 can have an aspect ratio of about 5 to about 10,000. In another embodiment, the shell 102 can have an aspect ratio of to about 10 to about 5,000. In yet another embodiment, the shell 102 can have an aspect ratio of to about 20 to about 1,000.

As noted above, it is desirable for the shell to have a high thermal conductivity while having a coefficient of expansion that is substantially similar to that of a semiconductor. The material used in the shell features adequately high thermal conductivity for heat spreading, high strength to withstand external and internal working pressures, sufficient hermeticity for long life and compatibility with add-on circuitry build-up by low-temperature-co-fired-ceramic (LTCC) or flexible circuit lamination. Both the first portion 110 and the second portion 120 of the shell 102 can comprise metals, ceramics, organic polymers, or a combination comprising at least one of the foregoing materials. Other materials such as carbon in its various forms such as, for example, graphite, diamond, and graphite-like materials can be used in the shell. The shell can be manufactured from a laminate, a composite, or the like.

As noted above, the shell can comprise metals. Examples of suitable metals are gold, platinum, silver, palladium, copper, aluminum, nickel, cobalt, titanium, tin, or the like, or a combination comprising at least one of the foregoing metals. The shell can comprise a metal that is in the form of a laminate or in the form of a single unitary indivisible piece of metal. The shell can also comprise metal alloys. Exemplary metals that can be used in the shell are copper laminates, copper, tungsten alloys and copper-molybdenum laminates.

Examples of suitable ceramics are oxides, nitrides, carbides, and the like. Examples of suitable oxides are silicon dioxide, titanium dioxide, aluminum oxide, zirconium dioxide, cerium oxide, or a combination comprising at least one of the foregoing oxides. Examples of suitable nitrides are aluminum nitride, gallium nitride, indium nitride, titanium nitride, boron nitride, silicon nitride, or a combination comprising at least one of the foregoing nitrides. Examples of suitable carbides are titanium carbide, silicon carbide, zirconium carbide, tantalum carbide, tungsten carbide, boron carbide, chromium carbide, molybdenum carbide, aluminum-silicon carbide or a combination comprising at least one of the foregoing carbides. An exemplary ceramic is aluminum nitride.

As noted above, the shell may comprise carbon in its various forms. The shell can comprise graphite composites, diamond composites, diamond-like carbon, carbon fiber composites, or a combination comprising at least one of the foregoing forms of carbon. Exemplary carbonaceous shells are those that comprise diamond, diamond-like carbon or graphite. An organic polymer may bind the carbon used in the shell. Examples of organic polymers are provided below.

Examples of suitable organic polymers are polyacetals, polyolefins, polyacrylics, polycarbonates, polystyrenes, polyesters, polyamides, polyamideimides, polyarylates, polyarylsulfones, polyethersulfones, polyphenylene sulfides, polyvinyl chlorides, polysulfones, polyimides, polyetherimides, polytetrafluoroethylenes, polyetherketones, polyether etherketones, polyether ketone ketones, polybenzoxazoles, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, polysiloxanes, polybutadienes, polyisoprenes, polynitriles, or the like, or a combination comprising at least one of the foregoing polymers. Exemplary organic polymers are elastomeric organic polymers. An exemplary elastomeric organic polymer is polysiloxane.

The shell has a thermal conductivity greater than or equal to about 10 W/m-K. In one embodiment, the shell has a thermal conductivity of about 20 to about 2000 W/m-K. In another embodiment, the shell has a thermal conductivity of about 50 to about 1000 W/m-K. In yet another embodiment, the shell has a thermal conductivity of about 100 to about 400 W/m-K.

The shell has a coefficient of thermal expansion of about -10 to about +10 ppm/degree Kelvin when measured at room temperature. In one embodiment, the shell has a coefficient of thermal expansion of about 0 to about 8 ppm/degree Kelvin. In another embodiment, the shell has a coefficient of thermal expansion of about 3 to about 6 ppm/degree Kelvin.

The shell 102 may have a wall thickness of about 250 micrometers to about 3 millimeters. In one embodiment, the shell may have a wall thickness of about 1,000 micrometers to about 2.5 millimeters. In another embodiment, the shell may have a wall thickness of about 1,500 micrometers to about 2 millimeters.

With reference to the Figure 1, the heat transfer device may have a thickness "T" of greater than or equal to about 100 nanometers. In one embodiment, the sides of the square can be about 200 nanometers to about 20 centimeters. In another embodiment, the sides of the square can be about 500 nanometers to about 10 centimeters. In yet another embodiment, the height of the square can be about 1,000 nanometers to about 1 centimeter. In an exemplary embodiment, the heat transfer device can have a thickness "T" of up to about 1 micrometer to about 1 millimeter.

The shell 102 may optionally be provided with ribs or support structures (e.g., pillars, posts, and the like) for enhancing mechanical stability of the heat transfer device. As the size of the heat transfer device increases, the need for internal support/joining structures may arise. Such structures could be individually placed or formed on either the first portion 110 or the second portion 120 of the shell 102 and joined during the assembly process, providing strength for the shell 102 to survive the internal and external pressures.

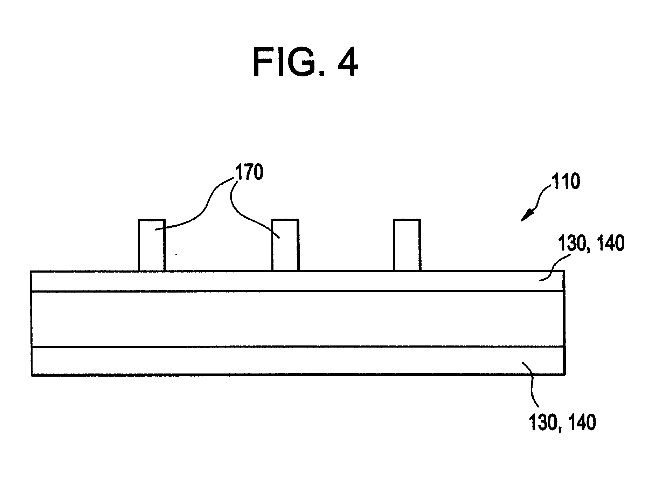

In one embodiment, a single rib or a plurality of ribs may be disposed upon the surface of the shell. Figure 4 depicts ribs 170 disposed upon the inner surface of the first portion 110. While not specifically depicted, ribs may be disposed upon the inner surface of the second portion 120 as well. The ribs may be manufactured from the same material as the first portion or the second portion or they may be manufactured from another material.

The seal ring 112 may be manufactured from materials that are chosen based on a matching of properties of the material used in the seal ring with that used in the first portion 110 and the second portion 120 of the shell 102. In one embodiment, it is desirable for the material used in the seal ring to have similar thermo-mechanical properties (elastic modulus, coefficient of thermal expansion) to that of the material used in the shell 102. In addition, it is desirable for the seal to display hermeticity and adhesion strength to bond the first portion 110 and the second portion 120 together to provide an air tight seal so that matter from inside the shell cannot be exchanged with the outside during the operation of the heat transfer device.

In an exemplary embodiment, it is desirable for the material used in the seal ring 112 and/or the metal stack 108 to have a coefficient of thermal expansion (CTE) that is within 20% of the coefficient of thermal expansion of the material used for the first portion 110 and the second portion 120 of the shell 102. In another embodiment, it is desirable for the material used in the seal ring 112 and/or the metal stack 108 to have a coefficient of thermal expansion that is within 10% of the coefficient of thermal expansion of the material used for the first portion 110 and the second portion 120 of the shell 102. In yet another embodiment, it is desirable for the material used in the seal ring 112 and/or the metal stack 108 to have a coefficient of thermal expansion that is within 5% of the coefficient of thermal expansion of the material used for the first portion 110 and the second portion 120 of the shell 102. Additionally, higher coefficient of thermal expansion materials may be utilized if the material modulus is low enough such that the stress imparted to the envelope seal is minimized. Such materials may include solder alloys.

In addition to matching coefficient of thermal expansions, it is desirable for the material used in the seal ring 112 and/or the metal stack 108 to have a low elastic modulus to minimize thermo-mechanical strain. The upper limit of the elastic modulus for the seal ring material is about 100x10⁵ Kg/cm². In an exemplary embodiment, the material for the seal ring and/or the metal stack is a soldering material or a brazing material. Brazing materials and soldering materials are useful candidates for hermetic seals based on their compatibility with the materials used in the shell and also because of their operating temperatures, modulus and strength. The metal stack may comprise optional adhesion layers if desired.

Examples of metals used in soldering materials comprise bismuth, silver, gold, tin, indium, copper, zinc, antimony, or the like, or a combination comprising at least one of the foregoing metals. Exemplary solders are those that comprise bismuth and tin, (Bi/Sn), gold and tin (Au/Sn), tin and lead (Sn/Pb), tin and silver (Sn/Ag), indium and tin (In/Sn), or the like, or a combination comprising at least one of the foregoing solders.

Examples of metals (or non-metals) used in brazing materials comprise aluminum, bronze, brass, tin, silicon, copper, nickel, silver, or the like, or a combination comprising at least one of the foregoing metals or non-metals. Exemplary brazing materials are aluminum and bronze (Al/bronze), aluminum and brass (Al/brass), tin and brass (Sn/brass), silicon and bronze (Si/bronze), copper and nickel (Cu/Ni), nickel and silver (Ni/Ag), or the like, or a combination comprising at least one of the foregoing metals or non-metals. Other suitable materials for the seal rings are glass frits (with lead or lead-free).

In an exemplary embodiment, the seal ring 112 comprises a glass frit, while the metal stack 108 can comprise the aforementioned soldering materials or the brazing materials.

Seal-substrate adhesion can be enhanced via additional optional adhesion promoting layers (not shown in the Figures). The adhesion promoting layers can include metals such as titanium (Ti), chromium (Cr), tungsten (W) and titanium-tungsten alloys (TiW). The adhesion promoting layers can have a thickness of about 100 to about 1000 nanometers. In one embodiment, the adhesion-promoting layer can have a thickness of about 125 to about 175 nanometers.

The seal ring surface may be optionally subjected to chemical treatments and/or mechanical treatments to provide surface texture (roughness) or chemical compatibility with the materials used in the shell 102 or the metal stack 108.

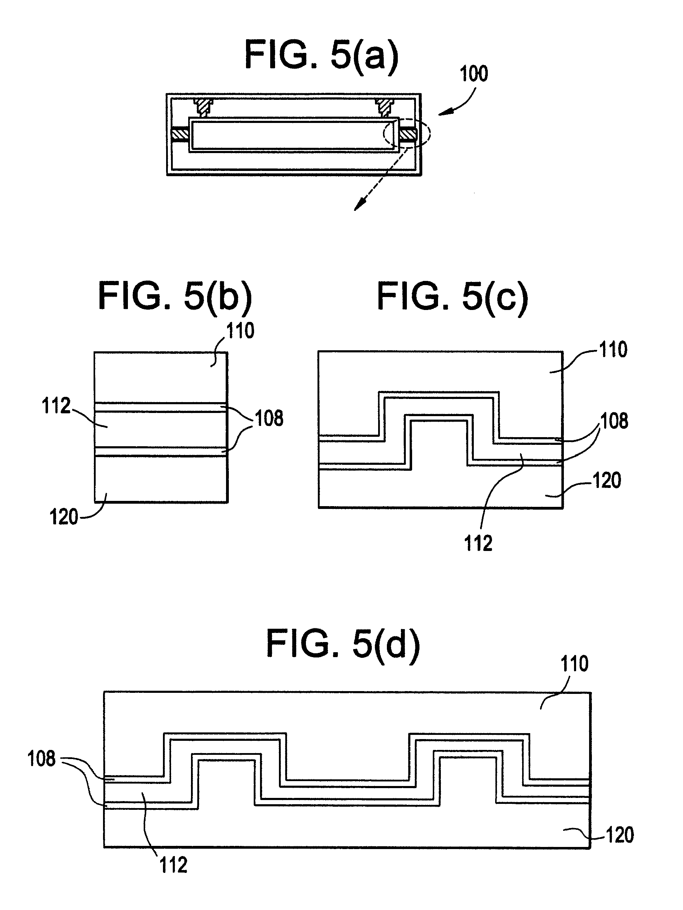

As shown in the Figure 5, the seal ring 112 and/or the metal stack 108 can have an untextured surface or a textured surface. While the Figure 5 depicts the groove as being in the first portion 110 and the second portion 120 of the shell 102, it is possible for the groove to be present in either the metal stack 108 or in the seal ring 112. A textured surface can include a variety of grooves for accurate interlocking of the first portion 110 with the second portion 120 of the shell 102. As seen in the Figure 4, the seal ring can include a single groove or a plurality of grooves.

With reference to the Figure 5, the Figure 5(a) depicts the heat transfer device with a section that encloses the seal ring being encircled. The Figures 5(b), 5(c) and 5(d) are expanded views of the encircled regions. The Figure 5(b) depicts an untextured surface, while the Figure 5(c) and 5(d) depict textured surfaces. The Figure 5(c) depicts a single groove disposed between the first portion 110 and the second portion 120 of the shell 102, while the Figure 5(d) depicts a multiple grooves disposed between the first portion 110 and the second portion 120 of the shell 102.

The textured surface can include a variety of different joints for locating and/or sealing the first portion 110 and the second portion 120 of the shell 102. These joints include dove tail joints, mortise and tenon joints, lap joints, finger joints, tongue and groove joints, miter joints, and the like. Dowels may also be used for location and sealing of the first portion 110 and the second portion 120 of the shell 102.

These chemical and/or mechanical treatments may include the use of sealing materials with low inherent hermeticity along with additional external/internal barrier coatings or board passivation enclosing the seal area. The additional barrier coatings may include inorganic metal systems such as for example nickel (Ni), silica (SiO2), molybdenum (Mo), silicon nitride (Si₃N₄), alumina (Al₂O₃), or the like, or a combination comprising at least one of the foregoing barrier coatings.

Additional organic coupling layers may also be provided between the seal ring and the shell 102 and/or the metal stack 108. Examples of the organic coupling layers include organic materials and polymers. Examples of organic polymers are provided above. Other examples of organic coupling materials are acrylate-containing polymers, methacrylate-containing polymers, parylene, bis-silanes, or the like, or a combination comprising at least one of the foregoing coupling materials.

The seal ring 112 and/or the metal stack 108 disposed on the periphery of the first portion 110 and/or the second portion 120 can have a thickness "t" of about 1 to about 5 millimeters. In one embodiment, the seal ring 112 and/or the metal stack 108 disposed on the periphery of the first portion 110 and/or the second portion 120 can have a thickness of about 2 to about 4 millimeters.

The seal ring 112 generally has a height "h" (see Figure 2) of about 50 to about 500 micrometers. In one embodiment, the seal ring 112 generally has a height "h" of about 100 to about 400 micrometers. In another embodiment, the seal ring 112 generally has a height "h" of about 150 to about 350 micrometers.

The metal stack 108 generally has a thickness "h₁" (see Figure 2) of about 500 nanometers to about 2 micrometers. In one embodiment, the metal stack has a thickness "h₁" of about 500 nanometers to about 2 micrometers.

The passivation layer 130 provides passivation against the formation of chemical erosion, which generally results from the formation of galvanic cells on the surface of the shell. As noted above, the passivation layer 130 is disposed on the outside of the shell 102 as well as on the inside of the shell 102. The passivation layer 130 generally comprises barrier coatings such as nickel, molybdenum, and the like, having a thickness of about 200 to about 5,000 nanometers.

The stack for adhesion 140 facilitates the adhesion onto the heat source and the heat sink. The stack for adhesion can comprise metals such as chromium, titanium, tungsten, and the like. The stack for adhesion has a thickness of about 100 to about 200 nanometers.

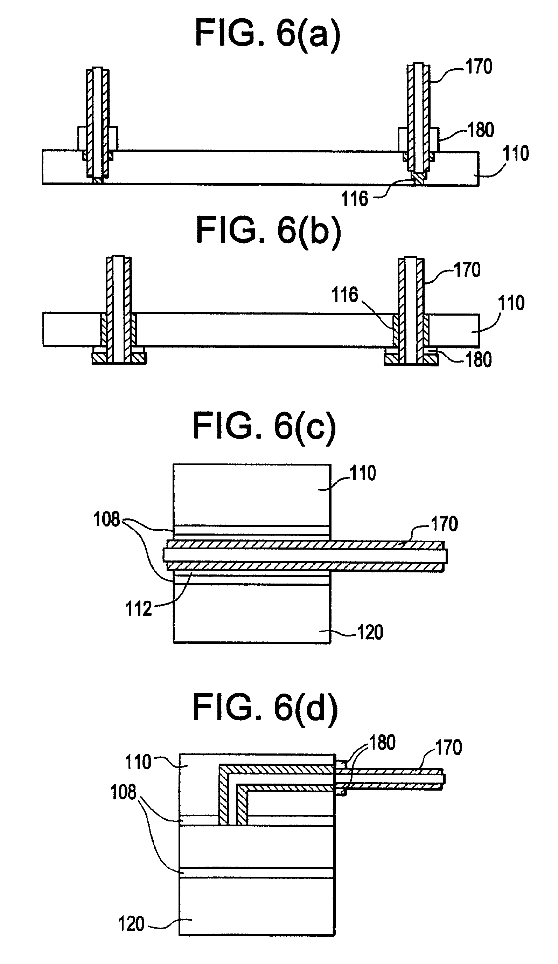

The ports 116 can be disposed on the first portion 110 and the second portion 120 to facilitate the charging and discharging of the fluid in the shell. The port 116 can be disposed in the particle layer 160 if desired. Alternatively, the port 116 can be disposed only in the first portion 110 and/or the second portion 120. A variety of fluids may be used in the shell. An exemplary fluid is water. In order to charge and discharge the shell, the corresponding plug 118 is removed and an attachment such as a tube, a pipe, a syringe or a funnel may be disposed into the port. The Figure 6 exemplifies various methods that can be used to fill the shell. The Figures 6(a), (b), (c) and (d) depict various methods that can be employed to fill the shell with the fluid.

While the Figure 6(a) and (b) depict charging the heat transfer device (with a fluid) via the port 116 in the shell, the Figures 6(c) and (d) depict filling the heat transfer device through ports created in the seal ring 112.

The port 116 can have a minimum diameter of about 100 micrometers to about 5 millimeters. In one embodiment, the port 116 can have a minimum diameter of about 600 micrometers to about 3 millimeters. In yet another embodiment, the port 116 can have a minimum diameter of about 700 micrometers to about 1 millimeters.

As noted above, a particle layer 160 is disposed on the inner surfaces 109 and 119 of the first portion 110 and the second portion 120. The materials used in the particle layer as well as the dimensions of the particle layer are described in copending applications having serial numbers 12/470,624 and 12/470,723, the entire contents of which are hereby incorporated by reference.

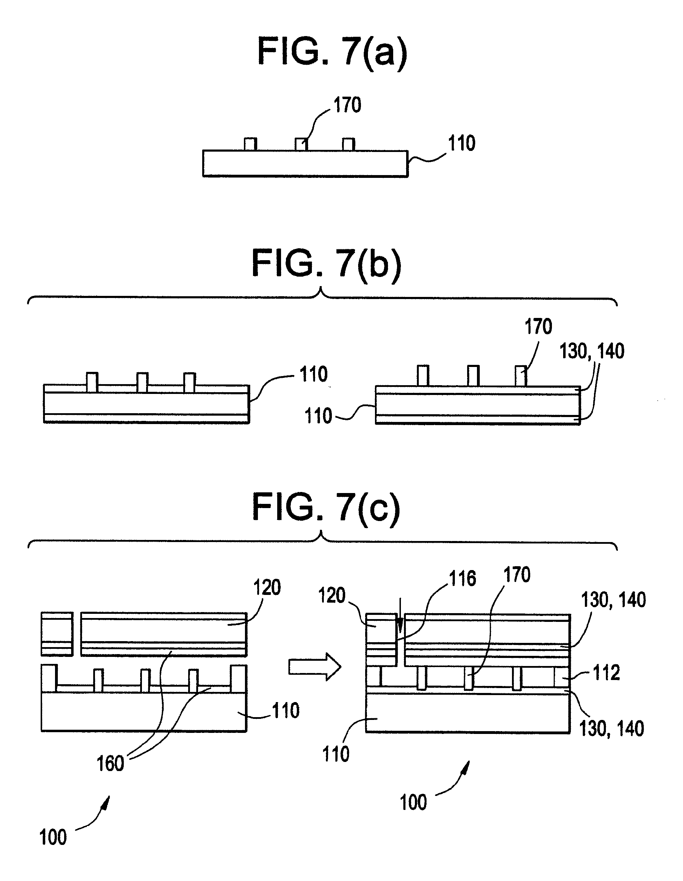

The Figure 7 depicts various exemplary parts of the heat transfer in their various configurations. The Figure 7 also depicts various methods for assembling and manufacturing the heat transfer device. The Figure 7 depicts various exemplary embodiments of the first portion 110 in the Figures 7(a) and 7(b) respectively. The Figure 7(a) depicts ribs 170 disposed upon the first portion 110 and in intimate contact with the first portion 110.

The Figure 7(b) shows two embodiments that depict ribs 170 disposed upon the first portion 110 and in intimate contact with the first portion 110. In the embodiment, facing the viewer on the left, the passivation layer 130 and/or a stack for adhesion 140 are disposed upon the first portion 110, but is disposed between the ribs 170 no under them. In the embodiment, facing the viewer on the right, the passivation layer 130 and/or a stack for adhesion 140 are disposed upon the first portion 110 with the ribs 170 disposed upon the passivation layer 130 and/or the stack for adhesion 140. Thus in one method of manufacturing the heat transfer device 100, the ribs may either be disposed directly upon the first and/or the second portions of the shell, following which the passivation layer and/or the stack for adhesion may be disposed upon the first portion 110 and/or the second portion 120 (not shown). In another method of manufacturing the heat transfer device 100, the passivation layer and/or the stack for adhesion may be first disposed upon the first portion 110 and/or the second portion 120 of the shell 102, following which the ribs are disposed on either the first and/or the second portion. It is to be noted that the first portion 110 and/or the second portion 120 may have a plurality of ports disposed in them prior to or after the disposing of the ribs, or prior to or after the disposing of the passivation layer 130 and/or the stack for adhesion 140.

The particle layer 160 may then be disposed upon the first portion and/or the second portion. This is depicted in the Figure 7(c), which depicts an exemplary embodiment of the assembly of the heat transfer device 100. From the Figure 7(c), after the deposition of the particle layer 160, the seal ring 112 and the metal stack 108 (not shown) may be disposed on the periphery of the first portion 110 and/or the second portion 120. The first portion and or the second portion and then sealed together. The heat transfer device may be charged with a suitable fluid and the plug 118 is disposed in the optional ports 116 to seal of the device and to form an air tight heat transfer device.

The heat transfer device thus formed may be disposed on a surface of a heat source (e.g., a semiconductor device, a nuclear plant heat pipe, or the like). The matching coefficient of friction provides a suitable match between the heat source and the heat transfer device. The stack for adhesion 140 can be used to bond the heat transfer device with the heat source. A heat sink (not shown) can contact the heat transfer device to remove the heat transferred from the heat source. The functioning of the heat transfer device is described in copending applications having serial numbers 12/470,624 and 12/470,723, the entire contents of which are hereby incorporated by reference.

The shape, size and strength of the heat transfer device provide it with numerous advantages. Since the heat transfer device generally has a flat shape and can have a thickness of less than or equal to about 1 millimeter, it can be disposed on a circuit board to dissipate heat generated by the integrated circuits and chips disposed on the circuit board. The heat transfer device has a high modulus and acts as a low coefficient of thermal expansion substrate for low warpage and improved interconnect reliability. The heat transfer device may be used in electronic devices, in nuclear facilities, as insulation on pipes in chemical plants or in supercomputers, or the like.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention.

Various aspects of the present invention are defined in the following numbered clauses:
1. A heat transfer device comprising:
   a shell; the shell being an enclosure that prevents matter from within the shell from being exchanged with matter outside the shell during the operation of the heat transfer device; the shell having an outer surface and an inner surface; and
   a porous layer disposed on the inner surface of the shell; the porous particle layer having a thickness effective to enclose a vapor space between opposing faces; the vapor space being effective to provide a passage for the transport of a fluid; the heat transfer device having a thermal conductivity of greater than or equal to about 10 watts per meter-Kelvin and a coefficient of thermal expansion that is substantially similar to that of a semiconductor.
2. The heat transfer device of Clause 1, where the shell comprises a first portion and a second portion; the first portion and the second portion each comprising an inner surface and an outer surface; the first portion contacting the second portion via a seal ring, a metal stack or both the seal ring and the metal stack.
3. The heat transfer device of Clause 2, where the seal ring comprises a glass frit.
4. The heat transfer device of Clause 2, where the seal ring and the metal stack comprise a soldering material or a brazing material.
5. The heat transfer device of Clause 4, where the soldering materials comprise bismuth, silver, gold, tin, indium, copper, zinc, antimony, or a combination comprising at least one of the foregoing metals.
6. The heat transfer device of Clause 5, where the soldering materials comprise bismuth and tin, gold and tin, tin and lead, tin and silver, indium and tin, or a combination comprising at least one of the foregoing solders.
7. The heat transfer device of Clause 4, where the brazing materials comprise aluminum, bronze, brass, tin, silicon, copper, nickel, silver, or the like, or a combination comprising at least one of the foregoing metals or non-metals.
8. The heat transfer device of Clause 4, where the brazing materials comprise aluminum and bronze, aluminum and brass, tin and brass, silicon and bronze, copper and nickel, nickel and silver, or a combination comprising at least one of the foregoing metals or non-metals.
9. The heat transfer device of Clause 4, where the brazing materials are titanium, chromium, tungsten or titanium-tungsten alloys.
10. The heat transfer device of any one of Clauses 2 to 9, where the inner surface and/or the outer surface of the first portion and/or the second portion each have disposed thereon a passivation layer and/or a stack for adhesion.
11. The heat transfer device of any preceding Clause, where the shell has ribs disposed on its inner surfaces; the ribs providing the shell with an increased resistance against warpage.
12. The heat transfer device of any preceding Clause, where the heat transfer device has a coefficient of thermal expansion of about -10 to about +10 parts per million per degree Kelvin when measured at room temperature.
13. The heat transfer device of any preceding Clause, having a thickness of less than or equal to about 1 micrometer to about 5 millimeters.
14. The heat transfer device of any preceding Clause, where the shell comprises aluminum nitride, graphite composites, diamond composites, diamond-like carbon, carbon fiber composites, copper laminates, copper-molybdenum laminates, copper-tungsten alloys, or a combination thereof.
15. The heat transfer device of any preceding Clause, where the shell comprises a port for charging the heat transfer device with a fluid.
16. An article comprising the heat transfer device of any preceding Clause.
17. The article of Clause 16, where the article is an electronic device, a microelectronics assembly, a power plant, a nuclear plant, or a supercomputer.
18. A method for manufacturing a heat transfer device comprising:
   disposing a particle layer upon a first portion and a second portion of a shell; the particle layer being porous; the first portion and the second portion each having a thermal conductivity of greater than or equal to about 10 watts per meter-Kelvin and a coefficient of thermal expansion that is substantially similar to that of a semiconductor; and
   disposing a seal ring and/or a metal stack between the first portion and the second portion of the shell; where the first portion and the second portion are sealed in a manner to prevent matter from within the shell from being exchanged with matter outside the shell during the operation of the heat transfer device.
19. The method of Clause 18, further comprising disposing ribs upon opposing inner surfaces of the first portion or the second portion of the shell.
20. The method of Clause 18 or Clause 19, further comprising disposing a port in the first portion and/or in the second portion.
21. The method of any one of Clauses 18 to 20, further comprising disposing a passivation layer and/or a stack for adhesion on an inner surface or on outer surface of the first portion or the second portion of the shell.
22. The method of any one of Clauses 18 to 21, further comprising disposing the heat transfer device on a surface that is heated.
23. An article that uses the method of any of Clauses 18 to 22.

## Claims

1. A heat transfer device (100) comprising:
a shell (102); the shell (102) being an enclosure that prevents matter from within the shell (102) from being exchanged with matter outside the shell (102) during the operation of the heat transfer device (100); the shell (102) having an outer surface (111 and 121) and an inner surface (109 and 119) ; and
a porous layer disposed on the inner surface (109 and 119) of the shell (102); the porous particle layer (160) having a thickness effective to enclose a vapor space (150) between opposing faces; the vapor space (150) being effective to provide a passage for the transport of a fluid; the heat transfer device (100) having a thermal conductivity of greater than or equal to about 10 watts per meter-Kelvin and a coefficient of thermal expansion that is substantially similar to that of a semiconductor.

2. The heat transfer device (100) of Claim 1, where the shell (102) comprises a first portion (110) and a second portion (120); the first portion (110) and the second portion (120) each comprising an inner surface (109 and 119) and an outer surface (111 and 121) ; the first portion (110) contacting the second portion (120) via a seal ring (112), a metal stack (108) or both the seal ring (112) and the metal stack.

3. The heat transfer device (100) of Claim 2, where the seal ring (112) comprises a glass frit.

4. The heat transfer device (100) of Claim 2, where the seal ring (112) and the metal stack (108) comprise a soldering material and where the soldering materials comprise bismuth and tin, gold and tin, tin and lead, tin and silver, indium and tin, or a combination comprising at least one of the foregoing solders.

5. The heat transfer device (100) of Claim 2, where the seal ring (112) and the metal stack (108) comprise a brazing material and where the brazing materials comprise aluminum, bronze, brass, tin, silicon, copper, nickel, silver, or a combination comprising at least one of the foregoing metals or non-metals.

6. The heat transfer device (100) of any of Claims 2 to 5, where the inner surface (109 and 119) and/or the outer surface (111 and 121) of the first portion (110) and/or the second portion (120) each have disposed thereon a passivation layer (130) and/or a stack for adhesion (140).

7. The heat transfer device (100) of any preceding Claim, where the shell (102) has ribs (170) disposed on its inner surfaces (109 and 119); the ribs (170) providing the shell (102) with an increased resistance against warpage.

8. The heat transfer device (100) of any preceding Claim, where the heat transfer device (100) has a coefficient of thermal expansion of about -10 to about +10 parts per million per degree Kelvin when measured at room temperature.

9. The heat transfer device (100) of any preceding Claim, where the shell (102) comprises aluminum nitride, graphite composites, diamond composites, diamond-like carbon, carbon fiber composites, copper laminates, copper-molybdenum laminates, copper-tungsten alloys, or a combination thereof.

10. An article comprising the heat transfer device (100) of any preceding Claim.

11. The article of Claim 10, where the article is an electronic device, a microelectronics assembly, a power plant, a nuclear plant, or a supercomputer.

12. A method for manufacturing a heat transfer device (100) comprising:
disposing a particle layer (160) upon a first portion (110) and a second portion (120) of a shell (102); the particle layer (160) being porous; the first portion (110) and the second portion (120) each having a thermal conductivity of greater than or equal to about 10 watts per meter-Kelvin and a coefficient of thermal expansion that is substantially similar to that of a semiconductor; and
disposing a seal ring (112) and/or a metal stack (108) between the first portion (110) and the second portion (120) of the shell (102); where the first portion (110) and the second portion (120) are sealed in a manner to prevent matter from within the shell (102) from being exchanged with matter outside the shell (102) during the operation of the heat transfer device (100).

13. The method of Claim 12, further comprising disposing ribs (170) upon opposing inner surfaces (109 and 119) of the first portion (110) or the second portion (120) of the shell (102) and further comprising disposing a port in the first portion (110) and/or in the second portion (120).

14. An article that uses the method of Claim 12 or Claim 13.
